# EUROPEAN PATENT APPLICATION

(11) **EP 1 244 150 A2**
(43) Date of publication of application: **25.09.2002**
(21) Application number: 02251852.6
(22) Date of filing: 15.03.2002
(51) Int. Cl.: H01L 29/78, H01L 29/423, H01L 21/336, H01L 21/28

(54) **Vertical MOSFET having a trench gate electrode and method of making the same**

(30) Priority: 19.03.2001 JP 2001078076
(71) Applicant: Kabushiki Kaisha Toshiba, Tokyo 105-8001 (JP)
(72) Inventor: Okumura, Hideki, c/o Intellectual Property Div., Minato-ku, Tokyo (JP); Osawa, Akihiko, c/o Intellectual Property Division, Minato-ku, Tokyo (JP); Ino, Takayoshi, c/o Intellectual Property Division, Minato-ku, Tokyo (JP)
(74) Representative: Granleese, Rhian Jane

(57) **Abstract**

A semiconductor device comprises a drain region (1') formed on the reverse side of a semiconductor substrate (1), a base region (2) formed on the drain region (1') and having parts partially exposed at plural positions on a principal plane of the substrate (1), a source region (3) which has one plane in contact with the base region (2) and the other plane exposed on the principal plane of the substrate (1), a gate insulating film (4) formed only on a wall of a trench (10), which is formed in the substrate (1) to reach the drain region (1'), a gate electrode (5) formed so as to be embedded in the trench (10) and a top surface thereof is situated above the junction plane of the source (3) and base (2) regions and at a position lower than the principal plane of the substrate (1), and an insulating film (6) embedded above the gate electrode (5) in the trench (10).

## Description

The present invention relates to a gate structure of a vertical power MOSFET in which a gate electrode is embedded in a trench formed in a semiconductor substrate and a side of the trench is used as a channel region, and a method of manufacturing the MOSFET.

A conventional vertical power MOSFET (will be referred to as "UMOS", hereinafter), in which a gate electrode is embedded in a trench formed on a semiconductor substrate and a side of the trench is used as a channel region, has a plurality of trenches in which gate electrodes made of polysilicon etc. are embedded, and pitches between the respective trenches are arranged at intervals of about 2.3 to 3.0 µm.

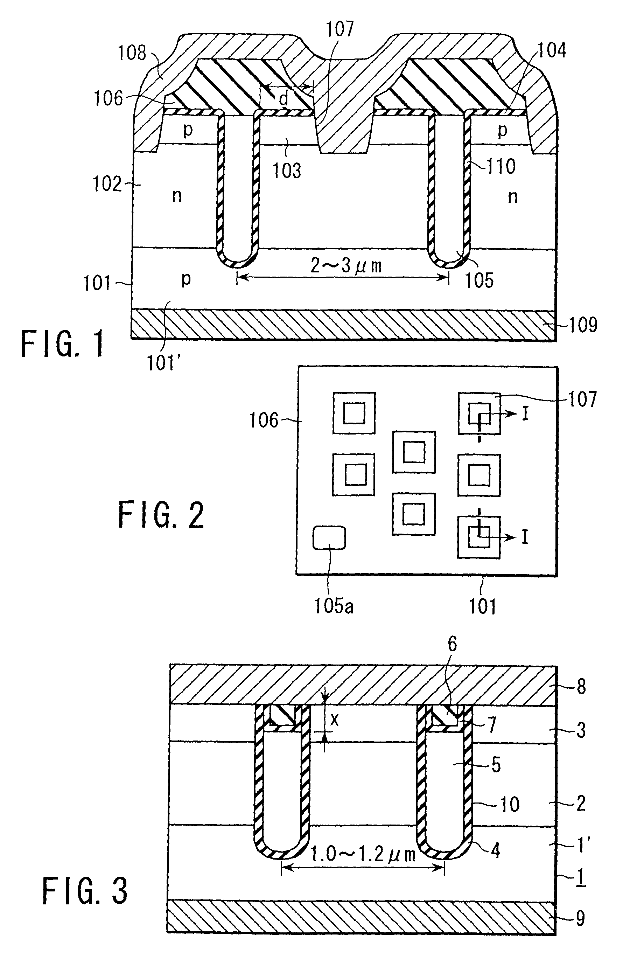

FIG. 1 is a cross-sectional view of a conventional trench contact type of UMOS, and FIG. 2 is a plan view of the same. Note that FIG. 1 is a cross-sectional view of a part along a line I-I shown in FIG. 2. A semiconductor substrate 101 employs, for example, a p-type of silicon substrate. In a surface region of the semiconductor substrate 101, an n-base region 102 doped with an n-type of impurities is formed. On the n-base region 102, a p-source region 103 constituting a principal plane of the semiconductor substrate 101 is formed. A region on the reverse side of the semiconductor substrate, where no such regions is formed, is defined as a p-drain region 101'.

A plurality of trenches 110 is formed from the principal plane of the semiconductor substrate 101 toward the inside thereof. Each of the trenches 110 extends from the principal plane, on which the p-source region 103 is formed, to a predetermined depth in the p-drain region 101'. On a wall of each trench 110, a gate insulating film 104 such as a silicon oxide film formed by thermal oxidation is formed.

The gate insulating film 104 extends from the sidewall of the trench 110 to the principal plane of the semiconductor substrate 101 around the trench, and a distance d of the extending portion between a tip portion thereof and a top edge of the trench 110 is about 0.4 to 0.5 µm.

A gate electrode 105 made of polysilicon etc., is embedded in the trench 110 which is coated with the gate insulating film 104. A surface of the polysilicon gate 105 is formed at almost the same level as the principal plane of the semiconductor substrate 101. On the surfaces of the polysilicon gate 105 and the gate insulating film 104 formed on the principal plane, an interlayer insulating film 106 such as a silicon oxide film made by CVD or the like is formed in a manner of accumulating thereon. In addition, on the surface of the semiconductor substrate 101, an opening 107 is formed between the adjacent trenches 110 in a manner of passing through the interlayer insulating film 106 and extending to the base region 102.

The openings 107 exist between the respective trenches 110, and are arranged in a staggered manner on the surface of the semiconductor substrate 101, as shown in FIG. 2. The polysilicon gates 105 embedded in the respective trench 110 are provided to electrically connect to each other (not shown), and electrically connected to a gate leading-out electrode 105a formed on the principal plane of the semiconductor substrate 101.

In the state described above, the principal plane of the semiconductor substrate 101 except for the openings 107 and the gate leading-out electrode 105a is coated by the interlayer insulating film 106. On the interlayer insulating film 106, a source electrode 108 is formed so as to be electrically insulated from the gate leading-out electrode 105a.

The source electrode 108 is embedded inside the opening 107 and electrically connected to the source region 103 and base region 102, both exposing to the inside of the opening 107. The source electrode 108 is made of, for example, aluminum. A barrier metal layer (not shown) is interposed between the source electrode 108 and the source region 103 and base region 102. On the reverse side of the semiconductor substrate 101, a drain electrode 109 electrically connected to the drain region 101' is formed.

However, in this structure, in order to maintain insulation of the polysilicon gate 105 from the source electrode 108 and secure a margin for aligning in an exposure technique, when the opening 107 is formed by etching the interlayer insulating film 106, a distance is provided between the top edge of the trench 110 and the edge of the opening 107. That is, at the part having the distance, the insulating film 106 is not removed by etching and remains together with the gate insulating film 104 located thereunder. The remaining width of the part is about 0.4 to 0.5 µm. This part is the extending part described above, and the distance d from the top edge of the trench 110 to the tip part of the extending part is equivalent to an insulating distance between the source electrode 108 and the polysilicon gate 105.

As described above, according to the structure, the interlayer insulating film 106 is so formed to have the remaining width d of 0.4 µm or more around the opening of the trench 110. In addition, it is necessary to prepare the opening width of 0.8 µm at the minimum so as to form the source and base leading-out electrode 108 so as to be embedded in the semiconductor substrate 101.

According to the above factors, in a conventional method, it is considered that a cell pitch of the trench is limited at least to 2 µm, and it is impossible to shrink narrower than 2 µm. Therefore, it has been desired to realize a semiconductor device comprising a vertical power MOSFET using a wall of its trench as a channel and a manufacturing method of the same, which makes it possible to shrink space of the cell pitches.

According to a first aspect of the present invention, there is provided a semiconductor device comprising:
a semiconductor substrate having a first and a second principal plane in parallel with each other;
a drain region formed in a layered manner in the semiconductor substrate which has two planes in parallel with each other, one of the two planes being exposed on the second principal plane of the semiconductor substrate;
a base region formed in the semiconductor substrate, being in contact with the other of the two planes of the drain region, and has parts partially exposed at plural portions on the first principal plane of the semiconductor substrate;
a source region formed in the semiconductor substrate which has one plane being in contact with the base region and the other plane exposed on the first principal plane of the semiconductor substrate, the source region and the base region being formed to have the same level on the first principal plane of the semiconductor substrate and forming a junction plane in the semiconductor substrate;
a gate insulating film formed substantially only on an inner wall of a trench which is formed from the first principal plane in a vertical direction such that a bottom face of the trench is arranged in the drain region;
a gate electrode embedded in the trench and formed such that a top surface of the gate electrode is situated above the junction plane of the source region and the base region and at a position lower than the first principal plane of the semiconductor substrate;
an embedded insulating film embedded in a part of the rench on the gate electrode; and
a source electrode formed on the first principal plane of the semiconductor substrate and in contact with the source region and the base region.

According to a second aspect of the present invention, there is provided a semiconductor device comprising:
a semiconductor substrate having a first and a second principal plane in parallel with each other;
a drain region which is formed in a layered manner in the semiconductor substrate which has two planes in parallel with each other, one of the two planes being exposed on the second principal plane of the semiconductor substrate;
a base region formed in the semiconductor substrate, being in contact with the other of the two planes of the drain region, and has parts partially exposed at plural portions on the first principal plane of the semiconductor substrate;
a source region formed in the semiconductor substrate which has one plane being in contact with the base region and the other plane exposed on the first principal plane of the semiconductor substrate, the source region and the base region being formed to have the same level on the first principal plane of the semiconductor substrate and forming a junction plane in the semiconductor substrate;
a gate insulating film formed on an inner wall of a trench which is formed from the first principal plane in a vertical direction such that a bottom face of the trench is arranged in the drain region, and extending to the first principal plane;
a gate electrode embedded in the trench and formed such that a top surface of the gate electrode is situated above the junction plane of the source region and the base region and at a position lower than the first principal plane of the semiconductor substrate;
an embedded insulating film formed on the top surface of the gate electrode and on the gate insulating film formed on the first principal plane and in the trench, a distance between the first principal plane of the semiconductor substrate and the top surface of the gate electrode being longer than a distance between a top edge of the trench and a tip end of the extending part of the gate insulating film; and
a source electrode formed in the first principal plane of the semiconductor substrate and in contact with the source region and the base region.

According to a third aspect of the present invention, there is provide a method of manufacturing a semiconductor device comprising:
forming a drain region in a semiconductor substrate, which has one plane exposing on a reverse surface of the semiconductor substrate, a base region in the semiconductor substrate, which is in contact with the other plane of the drain region and has parts partially exposed at plural portions on a principal plane of the semiconductor substrate, a source region in the semiconductor substrate, which has one plane being in contact with the base region and the other plane exposed on the principal plane of the semiconductor substrate, the source region and the base region being formed to have the same level on the principal plane of the semiconductor substrate and forming a junction plane in the semiconductor substrate;
forming a trench from the principal plane of the semiconductor substrate in a vertical direction such that a bottom face of the trench is arranged in the drain region;
forming a gate insulating film substantially only on an inner wall of the trench;
forming a gate electrode such that the gate electrode is embedded in the trench and a top surface of the gate electrode is situated above the junction plane of the source region and the base region and at a position lower than the principal plane of the semiconductor substrate;
depositing an insulating film having a reflow property on the gate electrode;
etching the insulating film having the reflow property by dry etching to leave the insulating film at least on an upper portion of the trench;
heating the left insulating film so as to reflow; and
forming a source electrode on the principal plane of the semiconductor substrate so as to be in contact with the source region and the base region.

According to a fourth aspect of the present invention, there is provided a method of manufacturing a semiconductor device comprising:
forming a drain region in a semiconductor substrate, which has one plane exposing on a reverse surface of the semiconductor substrate, a base region in the semiconductor substrate, which is in contact with the other plane of the drain region and has parts partially exposed at plural portions on the principal plane of the semiconductor substrate, a source region in the semiconductor substrate, which has one plane being in contact with the base region and the other plane exposed on the principal plane of the semiconductor substrate, the source region and the base region being formed to have the same level on the principal plane of the semiconductor substrate and forming a junction plane in the semiconductor substrate;
forming a trench from the principal plane of the semiconductor substrate in a vertical direction such that a bottom face of the trench is arranged in the drain region;
forming a gate insulating film in an inside of the trench, and extending on the principal plane of the semiconductor substrate;
forming a gate electrode such that the gate electrode is embedded in the trench, a surface of the gate electrode is situated above the junction plane of the source region and the base region and at a position lower than the principal plane of the semiconductor substrate, and a distance between the principal plane of the semiconductor substrate and the surface of the gate electrode is longer than a distance between a top edge of the trench and an extending end of the gate insulating film on the principal plane of the semiconductor substrate;
depositing an insulating film having a reflow property on the gate insulating film;
arranging a mask having a predetermined pattern on the insulating film having the reflow property, etching by anisotropic etching with use of the mask, thereby leaving the insulating film having the reflow property on the upper portion of the gate electrode and on the gate insulating film around the trench;
performing reflow to the etched insulating film having the reflow property so as to completely embed the insulating film in the trench and make a surface of the insulating film round; and
forming a source electrode coming into contact with the source region and the base region on the principal plane of the semiconductor substrate.

This summary of the invention does not necessarily describe all necessary features so that the invention may also be a sub-combination of these described features.

The invention can be more fully understood from the following detailed description when taken in conjunction with the accompanying drawings, in which:
FIG. 1 is a partial cross-sectional view of a semiconductor device having a conventional UMOS structure;
FIG. 2 is a plan view of the semiconductor device shown in FIG. 1;
FIG. 3 is a partial cross-sectional view of a semiconductor device having a UMOS structure according to a first embodiment of the invention;
FIG. 4 is a perspective view of a semiconductor substrate according to the first embodiment;
FIG. 5 is a cross-sectional view along V-V line in FIG. 4;
FIG. 6 is a plan view of the semiconductor device according to the first embodiment, a cross-sectional view along III-III line in FIG. 6 is shown in FIG. 3;
FIG. 7 is a cross-sectional view for explaining a method of manufacturing the semiconductor device according to the first embodiment;
FIG. 8 is a cross-sectional view of a semiconductor device having a UMOS structure according to a second embodiment;
FIG. 9 is a perspective view of the semiconductor substrate according to the second embodiment;
FIG. 10 is a cross-sectional view along X-X line in FIG. 9;
FIG. 11 is a plan view of the semiconductor device according to the second embodiment, a cross-sectional view along VIII-VIII line in FIG. 11 is shown in FIG. 8;
FIGS. 12A and 12B are cross-sectional views for explaining a method of manufacturing the semiconductor device according to the second embodiment;
FIG. 13 is a cross-sectional view showing the entire semiconductor substrate of the second embodiment;
FIG. 14 is a cross-sectional view of the semiconductor device having the UMOS structure according to the third embodiment;
FIG. 15 is a cross-sectional view for explaining a method of manufacturing the semiconductor device according to the third embodiment; and
FIG. 16 is a cross-sectional view of the third embodiment, corresponding to FIG. 10 in the second embodiment.

Embodiments to be described hereinafter have the following characteristics. A gate electrode made of polysilicon etc., which is embedded in a trench, is formed so as to be retreated by a predetermined depth from a principal plane of a semiconductor substrate made of silicon or the like. The predetermined depth is determined to satisfy a rated voltage between a source and gate after embedding an insulating film. Then, an insulating film having a reflow property is embedded in the trench, and dry etching, anisotropic etching or CMP (Chemical Mechanical Polishing) is performed to the insulating film so as to remain the insulating film on only the top of the trench. After that, the insulating film is reflowed. Then, metal wiring to be connected electrically to a source region and base region is formed as a source electrode.

In the embodiments of the present invention, when it is assumed that a distance to retreat the gate electrode made of polysilicon etc. embedded in the trench from the principal plane of the semiconductor substrate is xµm and a distance between the top edge of the trench and the termination of the gate insulating film is yµm, conditions such as x > y, x ≧ 0.2 and 0 ≦ y ≦ 0.3 are imposed. In this case, the thickness of x + y is substantially equivalent to the insulating distance between the source electrode and gate electrode.

More specifically, in the semiconductor device (FIG. 1) having a conventional structure, the insulating distance between respective electrodes must be arranged substantially in a horizontal direction of the substrate. However, in the embodiments of the invention, the insulating distance can be also arranged in a vertical direction of the substrate and thus the distance between the trenches can be shrunken.

In addition, it is not necessary the opening part (107 in FIG. 1) which has been needed to bring the source electrode into contact with the base region and source region, thereby further improving shrinkage of the distance between the trenches.

Furthermore, an interlayer insulting film having a reflow property in the trench is embedded, and then the interlayer insulting film is reflowed. After that, the source electrode as an electrode in the source and base region is formed of metal. Therefore, the principal plane of the semiconductor substrate becomes flat and thus it becomes easy to form a metal film made of aluminum etc., which will serve as the source electrode.

In addition, when a silicon nitride film is interposed between the gate insulating film and reflow insulating film, this silicon nitride film can be used as a stopper in etching the interlayer insulating film by anisotropic etching. In this case, even when there is misalignment in a contact exposure and a portion that is abnormally etched, it is possible to return a proper state by the reflow process.

In addition, when the silicon nitride film is used as a liner in the trench, phosphorus and boron, which are included in a BPSG (Boron-doped Phospho-Silicate Glass) film to be used as the reflow insulating film, do not come into the gate electrode, thereby stabilizing characteristics of a transistor.

Embodiments of the invention will be described with reference to the accompanying drawings, hereinafter.

### (First Embodiment)

First of all, a first embodiment will be described with reference to FIGS. 3 to 7.

A p-type silicon semiconductor is used for a semiconductor substrate 1, for example. In a surface region of the semiconductor substrate 1, an n-base region 2 doped with an n-type of impurities is formed. A p-source region 3, whose one plane serves as a part of a principal plane of the semiconductor substrate 1, is formed so as to be in contact with the n-base region 2. A region on the reverse side of the semiconductor substrate 1, where no such regions are formed, is defined as a p-drain region 1'.

A plurality of longitudinal trench 10 is formed from the principal plane of the semiconductor substrate 1 toward the inside thereof. Each of the trench 10 extends from the principal plane on which the source region 3 is formed to a predetermined depth in the drain region 1'. That is, a bottom face of the trench 10 is formed in the drain region 1'. On a wall of each trench 10, a gate insulating film 4 such as a silicon oxide film made by thermal oxidation is formed. The gate insulating film 4 is formed to extend to a substantial opening edge of the trench 10. The gate insulating film 4 may be formed slightly lower than the principal plane of the semiconductor substrate 1 by an etching process.

A gate electrode 5 made of polysilicon or the like is embedded in the trench 10 coated with the gate insulating film 4. A surface of the polysilicon gate 5 is formed lower than the principal plane of the semiconductor substrate 1. A distance x between the surface of the polysilicon gate 5 and the principal plane of the semiconductor substrate 1 is arranged at 0.2 µm or more.

A depth of the polysilicon gate 5 from the principal plane of the semiconductor substrate 1 except for a gate leading-out part is formed shallower than a junction depth of the source 3 and base 2. On the surface of the polysilicon gate 5 and the surface of the gate insulating film 4, which exposes above the polysilicon gate 5, a silicon nitride film 7 having a thickness of about 10 to 100 nm is formed. On the silicon nitride film 7, an embedded (interlayer) insulating film 6 such as the BPSG having a high-rated reflow property is formed. The embedded insulating film 6 is entirely embedded in the trench 10 with its surface flattened by a reflow process. A film thickness of the embedded insulating film 6 in a depth direction is formed at 0.2 µm or more. An insulating distance from the surface of the polysilicon gate 5 to the source electrode 8 is formed so as to ensure a rated voltage (20V in this case) between the source and gate.

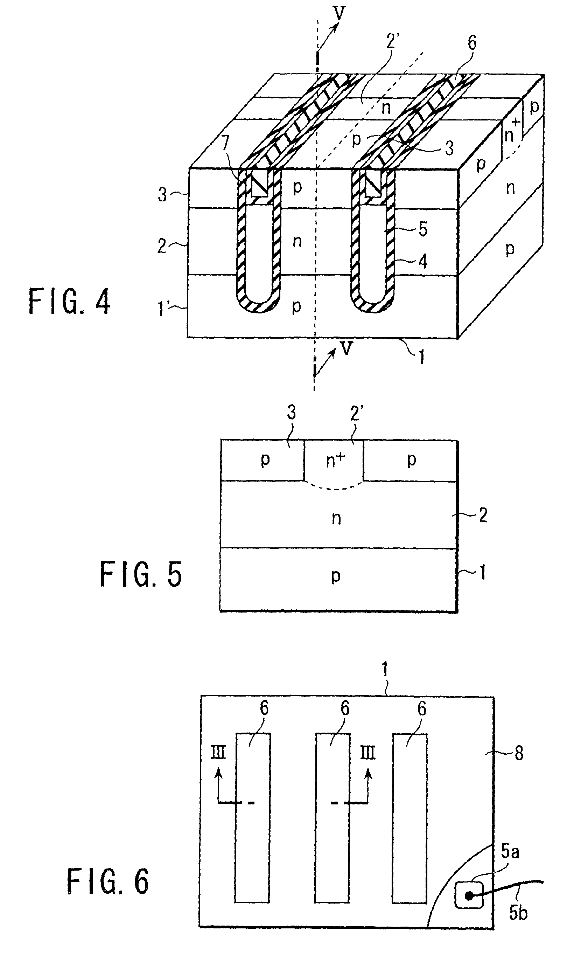

As shown in FIG. 4, in a source/base/drain region between the respective trenches 10, a highly doped n+ contact region 2' connected to the intermediate base region 2 is exposed at plural portions of the principal plane of the semiconductor substrate 1 (See FIG. 5). That is, on the principal plane of the semiconductor substrate 1, the source regions 3 and contact regions 2' are arranged alternately. On the source regions 3 and contact regions 2', the source electrode 8 electrically connected to both the region 3 and 2' is formed.

As shown in FIG. 4, the embedded insulating films 6 are formed almost only on the trenches 10 so that the source region 3 and base contact region 2' are exposed. The source electrode 8 is deposited thereon. The polysilicon gates 5 embedded in the respective trenches 10 are wired so as to be electrically connected to each other, and then eclectically connected to a gate leading-out electrode 5a formed on the principal plane of the semiconductor substrate 1. A lead wire 5a' is connected to the gate leading-out electrode 5a.

The source electrode 8 is made of, for example, aluminum. A part of the source electrode 8, which is connected to the source region 3 and contact regions 2, may be arranged with a barrier metal layer such as TiW film etc. interposed therebetween. On the reverse side of the semiconductor substrate 1, a drain electrode 9 electrically connected to the drain region 1' is formed.

In the present embodiment, since the surface of the gate is formed so as to be retreated from the principal plane of the semiconductor substrate, the distance x between the surface of the polysilicon gate and the principal plane of the semiconductor substrate is substantially the insulating distance between the gate electrode and source electrode.

In the conventional structure shown in FIG. 1, the remaining distance d of the gate insulating film with the interlayer insulating film coated is substantially an insulating distance. In the present embodiment, since the insulating distance is prepared in a vertical direction, a remaining width of the gate insulating film on the semiconductor substrate can be eliminated.

In addition, in the present embodiment, since contact regions of the base region are exposed to the principal plane of the semiconductor substrate, it is not necessary to form openings to bring the source region and base region into contact with the source electrode, which has conventionally been needed, so that narrowing a space between the trenches can be attained. Thus it becomes possible to shrink the pitch between the trenches efficiently. The silicon nitride film captures impurities such as phosphorus, boron or the like, which moves from the reflow insulating film to the gate electrode, with the result that characteristics of a transistor are stabilized.

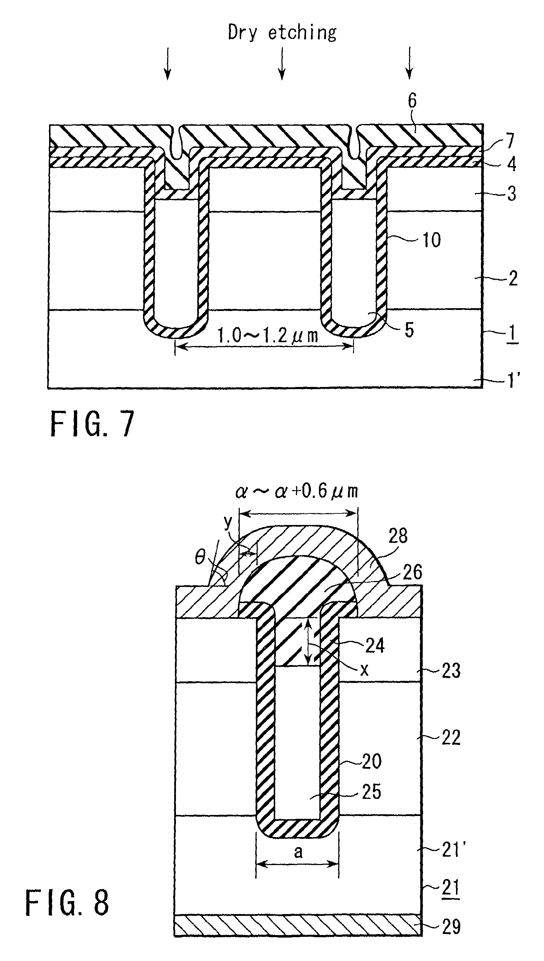

FIG. 7 is a cross-sectional view for explaining a method of forming a semiconductor device having the UMOS structure. On the p-drain region 1' of the semiconductor substrate 1, there are sequentially formed the n-base region 2, which exposes partially at plural portions on the principal plane of the semiconductor substrate 1, and the p-source region 3 whose one plane is in contact with the base region 2 and the other plane exposes on the principal plane of the semiconductor substrate 1.

Next, the trenches 10 are formed from the principal plane in a vertical direction such that bottom faces of the trenches are arranged in the drain region 1'. After that, a silicon oxide film is formed on the entire principal plane by a thermal oxidation process, and the gate insulating film 4 is formed substantially on only an inner wall of each trench 10 by patterning the silicon oxide film. Then, the polysilicon gate 5 is embedded in the trench 10 such that a surface of the polysilicon gate 5 is situated above the junction plane of the source region 3 and base region 2 and situated lower than the principal plane of the semiconductor substrate 1.

Next, the silicon nitride film 7 having a thickness of about 10 to 100 nm is formed on the principal plane of the semiconductor substrate 1 including the inside of the trench 10. And further, the insulating film 6 having a reflow property, such as a BPSG film etc., is deposited on the silicon nitride film 7. Then, the reflow insulating film 6 is etched by dry etching and embedded in an upper part of the trench 10, in which the polysilicon gate 5 is not embedded, with the silicon nitride film 7 interposed therebetween, up to almost the same level as the top surface of the semiconductor substrate 1.

Next, the embedded insulating film 6 having the reflow property is reflowed at about a temperature of 900 degree centigrade. The insulating film 6 having the reflow property is completely embedded in the trench 10.

After that, the drain electrode 9 is formed on the reverse side of the semiconductor substrate 1 so as to come into contact with the drain region 1', and the source electrode 8 in contact with the source region 3 and base region 2 is formed on the principal plane of the semiconductor substrate 1 by sputtering method or the like.

The thus-formed principal plane of the semiconductor substrate is flatter than conventional one so that adhesive property of the electrode to be formed thereon is improved.

The UMOS is formed by a structure wherein each of the trenches is formed longitudinally and in an elongated manner, the base contact region is exposed on the principal plane of the semiconductor substrate, and the interlayer insulating film is embedded in the trench. Therefore, no region for insulation between the gate and source is necessary on the semiconductor substrate. As a result, the cell pitch can be arranged at about 1.0 to 1.2 µm, which is narrower than conventional one.

An embodiment to be described next is a second embodiment in that it is easy to control irregularity in a film thickness of the interlayer insulating film in a flattening process and etching irregularity in a dry etching process.

### (Second Embodiment)

In the second embodiment, irregularity in a film thickness of the interlayer insulating film and etching irregularity in a dry etching process are controlled with use of the anisotropic etching such as RIE (Reactive Ion Etching) etc. In this method, there is a high possibility of arising misalignment in mask patterning so that another difficulty occurs. However, the difficulty can be solved by using an insulating film having a reflow property.

FIG. 8 is a cross-sectional view of a UMOS according to the second embodiment. A p-type of silicon semiconductor is used for a semiconductor substrate 21, for example. In a surface region of the semiconductor substrate 21, an n-base region 22 doped with an n-type of impurities is formed. A p-source region 23, whose one plane serves as a part of a principal plane of the semiconductor substrate 21, is formed so as to be in contact with the n-base region 22. A region on the reverse side of the semiconductor substrate 21, where no such regions is formed, is defined as a p-drain region 21'.

A plurality of longitudinal trench 20 is formed from the principal plane of the semiconductor substrate 21 toward the inside thereof. Each of the trench 20 extends from the principal plane on which the source region 23 is formed to a predetermined depth in the drain region 21'. That is, a bottom face of the trench 20 is formed in the drain region 21'.

On an inner wall of each trench 20, a gate insulating film 24 such as a silicon oxide film made by thermal oxidation is formed. The gate insulating film 24 slightly extends from the wall of the trench 22 over the principal plane of the semiconductor substrate 21 around the trench. A distance y of the extending part between a top edge of the trench 22 and the tip of the extending part is about 0 to 0.3 µm, which is shorter than the conventional one (0.4 to 0.5 µm).

A gate electrode 25 made of polysilicon etc. is embedded in the trench 20 coated with the gate insulating film 24. A surface of the embedded polysilicon gate 25 is formed lower than the principal plane of the semiconductor substrate 21. A distance x between the surface of the polysilicon gate 25 and the principal plane of the semiconductor substrate 21 is arranged at 0.2 µm or more. However, the distance y of the extending part of the gate insulating film 24 between a top edge of the trench 22 and the tip of the extending part and the distance x between the surface of the polysilicon gate and the principal plane of the semiconductor substrate are arranged to satisfy x > y. In addition, the shortest distance between the polysilicon gate 25 and the source electrode 28 (corresponding to a film thickness of the embedded insulating film 24 in a depth direction) is formed to secure 0.2 µm or more.

However, the polysilicon gate 25 except for a gate leading-out part is formed shallower than a junction depth of the source 23 and base 22. On the surface of the polysilicon gate 25 and the surface of the gate electrode 24, which exposes above the polysilicon gate 25, an embedded (interlayer) insulating film 26 such as the BPSG having a high-rated reflow property is formed. The embedded insulating film 26 is reflowed and thus has a round surface. An angle θ generated by a tangential line of the embedded insulating film 26 at its end part on the substrate against the substrate is arranged at 90 degree or less.

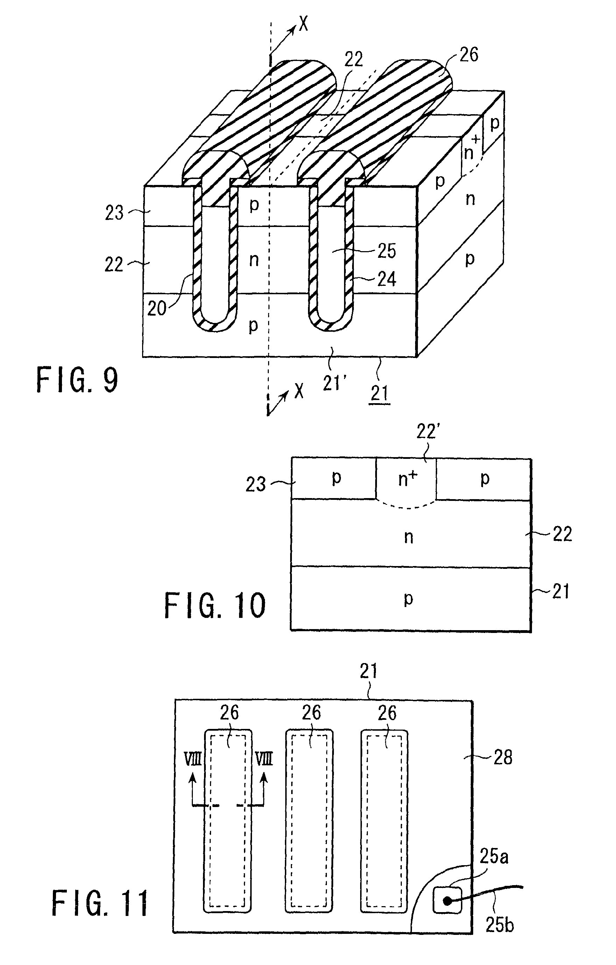

As shown in FIG. 9, in a source/base/drain region between the respective trenches 20, a highly doped n+ contact region 22' of the intermediate base region 22 is exposed at plural portions of the principal plane of the semiconductor substrate 21 (See FIG. 10). That is, on the principal plane of the semiconductor substrate 21, the source regions 23 and contact regions 22' are arranged alternately. On the source regions 23 and contact regions 22', the source electrode 28 electrically connected to both the region 23 and 22' is formed.

As shown in FIG. 11, the embedded insulating films 26 are formed almost only on the trenches 20 so that the source region 23 and base contact region 22' are exposed. The source electrode 28 is deposited thereon. The polysilicon gates 25 embedded in the respective trenches 20 are wired so as to be electrically connected to each other, and then eclectically connected to a gate leading-out electrode 25a formed on the principal plane of the semiconductor substrate 21. A lead wire 25b is connected to the gate leading-out electrode 25a.

The source electrode 28 is made of, for example, aluminum. A part of the source electrode 28, which is connected to the source region 23 and contact regions 22, may be arranged with a barrier metal layer such as TiW layer etc. interposed therebetween. On the reverse side of the semiconductor substrate 21, a drain electrode 29 electrically connected to the drain region 21' is formed.

In the present embodiment, since the surface of the gate is retreated from the principal plane of the semiconductor substrate, the sum (x + y) of the distance y of the extending part of the gate insulating film coated with the embedded film between the top edge of the trench and the tip of the extending part and the distance x between the surface of the polysilicon gate and the principal plane of the semiconductor substrate is substantially equivalent to the conventional distance d between the gate electrode and source electrode (about 0.4 to 0.5 µm). In the conventional structure shown in FIG. 1, the width of a part in the gate insulating film, which is coated with the interlayer insulating film, is a practical distance d. Therefore, the width of a part in the gate insulating film, which is left on the principal plane of the semiconductor substrate, can be reduced by the insulating distance taken in a vertical direction.

In addition, since contact regions in the base region are exposed on the principal plane of the semiconductor substrate, it is not necessary to form openings that have conventionally been provided to bring the source region and base region into contact with the source electrode, with the result that narrowing a space between the trenches is attained to the relevant extent. Thus it becomes possible to shrink the cell pitch between the trenches efficiently. In addition, since the surface of the interlayer insulating film has a round shape, an adhesive property of the source electrode to be formed thereon is improved, which makes it possible to attain a structure having a high mechanical strength and no wiring breakage due to a step.

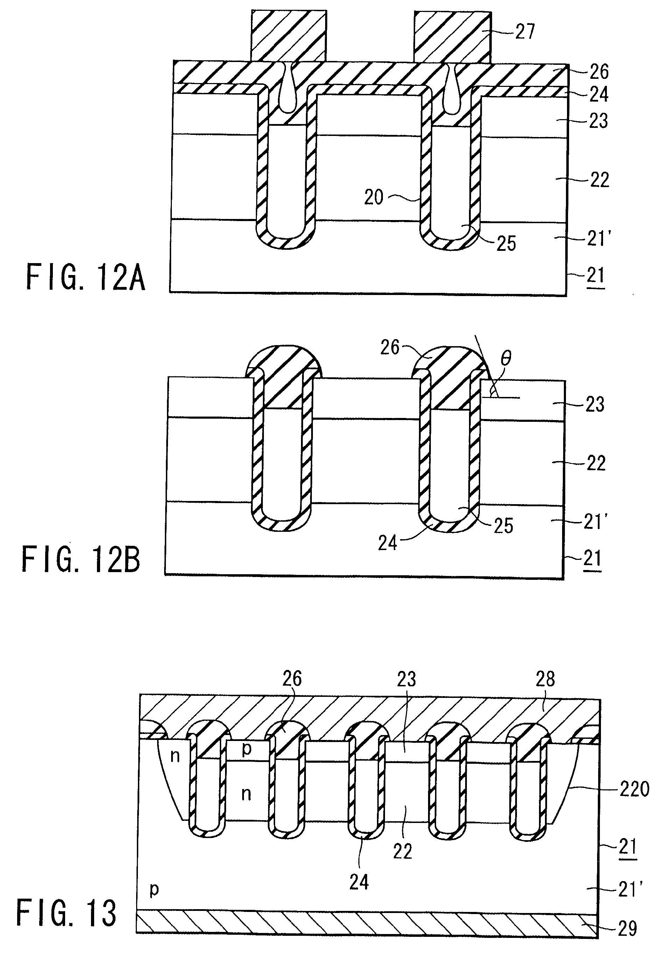

FIGS. 12A and 12B are cross-sectional views for explaining a method of manufacturing a semiconductor device having the UMOS structure. On the p-drain region 21' of the semiconductor substrate 1 made of silicon etc., there are sequentially formed the n-base region 22, which exposes partially at plural portions on the principal plane of the semiconductor substrate 21, and the p-source region 23 whose one plane is in contact with the base region 22 and the other plane exposes on the principal plane of the semiconductor substrate 21. Note that a process may be adopted in that the source is formed after forming the trench.

Next, the trenches 20 are formed from the principal plane in a vertical direction in a manner that bottom faces of the trenches are arranged in the drain region 1'. Then a gate insulating film 24 such as a silicon oxide film is formed on the principal plane of the semiconductor substrate 21 including the inner wall of the trench 20.

After that, a polysilicon film is deposited on the principal plane of the semiconductor substrate 21 including the inside of the trench 20, and a patterning process is performed to the deposited polysilicon film. Then, the gate electrode 25 made of polysilicon is embedded in the trench 20 such that a surface of the gate electrode 25 is situated above the junction plane of the source region 23 and base region 22 and situated lower than the principal plane of the semiconductor substrate 21. On the polysilicon gate 25 embedded in the trench 20 and the gate electrode 24, an insulating film having an excellent reflow property, such as the BPSG film etc. is deposited.

On the insulating film 26, a mask 27, which is made of photoresist and has a predetermined pattern, is arranged (FIG. 12A). The insulating film 26 is etched by the anisotropic etching with use of the mask 27, thereby leaving the insulating film 26 at a part of the trench 20 where the polysilicon gate 25 is not embedded and on the gate insulating film 24 formed on the brink of the trench 20. The mask 27 covers the trench 20 and its periphery. Assuming the opening width of the trench 20 is denoted by a, the mask 27 has the width of a to a + 0.6 µm. The insulating film 26 to which the patterning process has been performed is formed in accordance with the mask 27.

Next, after removing the photoresist mask 27, the insulating film 26 to which the patterning process has been performed by etching is reflowed at a temperature of 900 degree centigrade or more. As a result, the insulating film 26 is completely embedded in the trench 20 and the surface of the film 26 becomes round (FIG. 12B).

Next, the drain electrode 29 is formed on the reverse side of the semiconductor substrate 21 so as to come into contact with the drain region 1', and the source electrode 28 is formed on the principal plane side of the semiconductor substrate 21 so as to come into contact with the source region 23 and base region 22 (See FIG. 8).

According to the present embodiment, it is possible to shrink the cell pitch sufficiently. In addition, even when there is misalignment in a contact exposure for patterning the insulating film 26, it is possible to recover to a proper position through the reflow process.

FIG. 13 is a cross-sectional view of a semiconductor substrate, showing a semiconductor device in which the present embodiment has been completed. In the device, a plurality of base and source regions of the UMOS are formed in an n well 220, using the source electrode 28, the drain region 21' and the drain electrode 29 in common.

### (Third Embodiment)

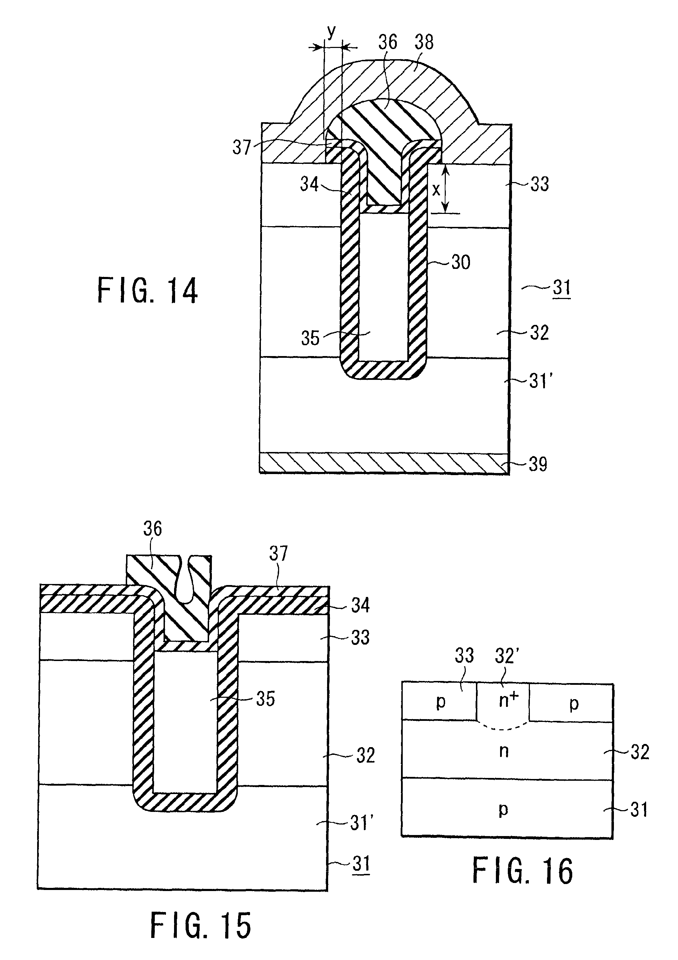

FIG. 14 is a cross-sectional view of a semiconductor device having the UMOS structure according to a third embodiment, and FIG. 15 is a cross-sectional view for explaining a method of manufacturing the same. The p-type silicon semiconductor is used for a semiconductor substrate 31, for example. In a surface region of the semiconductor substrate 31, an n-base region 32 doped with n-type impurities is formed. A p-source region 33, whose one plane serves as a part of the principal plane of the semiconductor substrate 31, is formed so as to be in contact with the n-base region 32. A region on the reverse side of the semiconductor substrate 31, where no such regions are formed, is defined as a p-drain region 31'.

A plurality of longitudinal trenches 30 are formed in the semiconductor substrate 31 from the principal plane thereof toward the inside thereof. Each of the trench 30 extends from the principal plane on which the source region 33 is formed to a predetermined depth in the drain region 31'. That is, a bottom face of the trench 30 is formed in the drain region 31'.

On an inner wall of each trench 30, a gate insulating film 34 such as a silicon oxide film made by thermal oxidation is formed. The gate insulating film 34 slightly extends from the top edge of the trench 32 over the principal plane of the semiconductor substrate 31 around the trench. A distance y of the extending part between the top edge of the trench 32 and the tip of the extending part is about 0 to 0.3 µm, which is shorter than the conventional one.

A gate electrode 35 made of polysilicon etc. is embedded in the trench 30 via the gate insulating film 34. A surface of the embedded polysilicon gate 35 is formed lower than the principal plane of the semiconductor substrate 31. And further, the embedded polysilicon gate 35 is formed shallower than a junction depth of the source 33 and base 32.

A distance x between the surface of the polysilicon gate 35 and the principal plane of the semiconductor substrate 31 is arranged at 0.2 µm or more. However, the distance y of the extending part of the gate insulating film 34 between the top edge of the trench and the tip of the extending part and the distance x between the surface of the polysilicon gate and the principal plane of the semiconductor substrate are arranged to satisfy x > y. In addition, the shortest distance between the polysilicon gate 35 and the source electrode 38 (corresponding to a film thickness of the embedded insulating film 34 in a depth direction) is arranged to have 0.2 µm or more in length, so as to secure a rated voltage of 20V between a source and gate.

A silicon nitride film 37 having a thickness of 10 to 100 nm is formed on a surface of the polysilicon gate 35 and a surface of the gate insulating film 34 that exposes above the polysilicon gate 35. On the silicon nitride film 37, an insulating film 36 such as the BPSG having a high-rated reflow property is embedded. The embedded insulating film 36 is reflowed and thus has a round surface. An angle θ generated by a tangential line at an end part of the embedded insulating film 36 with respect to the substrate plane is arranged at 90 degree or less.

As shown in FIG. 16, in a source/base/drain region between the respective trenches 30, a highly doped n+ contact region 32' connected to the intermediate base region 32 is exposed at plural portions of the principal plane of the semiconductor substrate 31. That is, on the principal plane of the semiconductor substrate 31, the source regions 33 and contact regions 32' are arranged alternately. On the source regions 33 and contact regions 32', the source electrode 38 electrically connected to both the region 33 and 32' is formed.

Similarly to FIG. 11, the embedded insulating films 36 are formed almost only above the trenches 30 so that the source region 23 and base contact region 32' are exposed. The source electrode 38 is deposited thereon. The polysilicon gates 35 embedded in the respective trenches 30 are wired so as to be electrically connected to each other, and then eclectically connected to a gate leading-out electrode formed on the principal plane of the semiconductor substrate 31 in the similar manner to the first and second embodiments. A lead wire is connected to the gate leading-out electrode.

The source electrode 38 is made of, for example, aluminum. A part of the source electrode 38, which is connected to the source region 33 and contact regions 32, may be arranged with a barrier metal layer such as TiW layer etc. interposed. On the reverse side of the semiconductor substrate 31, a drain electrode 39 electrically connected to the drain region 31' is formed.

In the present embodiment, since the surface of the gate is retreated from the principal plane of the semiconductor substrate, the sum (n + y) of the distance y of the extending part of the gate insulating film covered with the embedded film between the top edge of the trench and the tip of the extending part and the distance x between the surface of the polysilicon gate and the principal plane of the semiconductor substrate is substantially equivalent to the distance d between the gate electrode and source electrode. In the conventional structure shown in FIG. 1, the width of a part in the gate insulating film, which is covered with the interlayer insulating film, is a practical insulating distance. Therefore, the width of the part in the gate insulating film, which is left on the principal plane of the semiconductor substrate, can be reduced by virtue of the insulating distance taken in a vertical direction.

In addition, since contact regions in the base region are exposed on the principal plane of the semiconductor substrate, it is not necessary to form openings that have conventionally been provided to bring the source region and base region into contact with the source electrode, which allows narrowing space between the trenches to the relevant extent. Thus it becomes possible to shrink the cell pitch between the trenches efficiently. In addition, since the surface of the interlayer insulating film has a round shape, an adhesive property of the source electrode to be formed thereon is improved, which makes it possible to attain a structure having high mechanical strength and no wiring breakage at a step.

In addition, even if there is misalignment when the insulating film having a reflow property is etched by the anisotropic etching so as to form a contact (to perform a patterning process), the film is reflowed at a temperature of 900 degree centigrade or above after performing the patterning. Therefore, the insulating film is formed at a predetermined position due to the reflow and thus no problem occurs.

With the method of manufacturing according to the present embodiment, the insulating film is completely embedded in the trench by a reflow process. At the same time, corners of the film can be made round. In addition, the silicon nitride film is used not only for capturing phosphorus and boron coming from the insulating film having the reflow property but also serving as an etching stopper in the anisotropic etching.

As having described in the above embodiments, the semiconductor device according to the invention has a structure in that a vertical thickness of an insulating film is of great significance with respect to the insulating distance between the gate electrode and source electrode, rather than a horizontal length of the insulating film on the principal plane of the semiconductor substrate. In addition, it is not necessary to form openings to connect the source electrode to the source region and base region between trenches so that the cell pitch can be shrunken sufficiently.

Further, since the insulating film having the reflow property is used as the embedded insulating film so that the surface of the film can be flattened or made round. Therefore, the electrodes on the surface of the semiconductor substrate can be fixed firmly. Furthermore, even if there is misalignment in the contact exposure prior to the anisotropic etching, the device has an advantage such that the insulating film can be formed at a proper position through the reflow process.

## Claims

1. A semiconductor device, **characterized by** comprising:
a semiconductor substrate (1, 21, 31) having a first and a second principal plane in parallel with each other;
a drain region (1', 21', 31') formed in a layered manner in the semiconductor substrate (1, 21, 31) which has two planes in parallel with each other, one of the two planes being exposed on the second principal plane of the semiconductor substrate (1, 21, 31);
a base region (2, 22, 32) formed in the semiconductor substrate (1, 21, 31), which is in contact with the other of the two planes of the drain region (1', 21', 31'), and has parts partially exposed at plural portions on the first principal plane of the semiconductor substrate (1, 21, 31);
a source region (3, 23, 33) formed in the semiconductor substrate (1, 21, 31) which has one plane being in contact with the base region (2, 22, 32) and the other plane exposed on the first principal plane of the semiconductor substrate (1, 21, 31), the source region (3, 23, 33) and the base region (2, 22, 32) being formed to have the same level on the first principal plane of the semiconductor substrate (1, 21, 31) and forming a junction plane in the semiconductor substrate (1, 21, 31);
a gate insulating film (4, 24, 34) formed substantially only on an inner wall of a trench (10, 20, 30) which is formed from the first principal plane in a vertical direction such that a bottom face of the trench is arranged in the drain region (1', 21', 31');
a gate electrode (5, 25, 35) embedded in the trench (10, 20, 30) and formed such that a top surface of the gate electrode (5, 25, 35) is situated above the junction plane of the source region (3, 23, 33) and the base region (2, 22, 32) and at a position lower than the first principal plane of the semiconductor substrate (1, 21, 31);
an embedded insulating film (6, 26, 36) embedded in a part of the trench (10, 20, 30) on the gate electrode (5, 25, 35); and
a source electrode (8, 28, 38) formed on the first principal plane of the semiconductor substrate (1, 21, 31) and in contact with the source region (3, 23, 33) and the base region (2, 22, 32).

2. A semiconductor device, **characterized by** comprising:
a semiconductor substrate (1, 21, 31) having a first and a second principal plane in parallel with each other;
a drain region (1', 21', 31') formed in a layered manner in the semiconductor substrate (1, 21, 31) which has two planes in parallel with each other, one of the two planes being exposed on the second principal plane of the semiconductor substrate (1, 21, 31);
a base region (2, 22, 32) formed in the semiconductor substrate (1, 21, 31), being in contact with the other of the two planes of the drain region (1', 21', 31'), and has parts partially exposed at plural portions on the first principal plane of the semiconductor substrate (1, 21, 31);
a source region (3, 23, 33) formed in the semiconductor substrate (1, 21, 31) which has one plane being in contact with the base region (2, 22, 32) and the other plane exposed on the first principal plane of the semiconductor substrate (1, 21, 31), the source region (3, 23, 33) and the base region (2, 22, 32) being formed to have the same level on the first principal plane of the semiconductor substrate (1, 21, 31) and forming a junction plane in the semiconductor substrate (1, 21, 31);
a gate insulating film (4, 24, 34) formed on an inner wall of a trench (10, 20, 30) which is formed from the first principal plane in a vertical direction such that a bottom face of the trench is arranged in the drain region (1', 21', 31'), and extending to the first principal plane;
a gate electrode (5, 25, 35) embedded in the trench (10, 20, 30) and formed such that a top surface of the gate electrode (5, 25, 35) is situated above the junction plane of the source region (3, 23, 33) and the base region (2, 22, 32) and at a position lower than the first principal plane of the semiconductor substrate (1, 21, 31);
an embedded insulating film (6,26, 36) formed on the top surface of the gate electrode (5, 25, 35) and on the gate insulating film (4, 24, 34) formed on the first principal plane and in the trench, a distance (x) between the first principal plane of the semiconductor substrate (1, 21, 31) and the top surface of the gate electrode (5, 25, 35) being longer than a distance (y) between a top edge of the trench (10, 20, 30) and a tip end of the extending part of the gate insulating film (4, 24, 34); and
a source electrode (8, 28, 38) formed on the first principal plane of the semiconductor substrate (1, 21, 31) and in contact with the source region (3, 23, 33) and the base region (2, 22, 32).

3. The device according to anyone of claim 1 and 2, **characterized by** further comprising a drain electrode (9, 29, 39) formed on the second principal plane of the semiconductor substrate (1, 21, 31) so as to be in contact with the drain region (1', 21', 31').

4. The device according to anyone of claim 1 and 2, **characterized by** further comprising a silicon nitride film (7, 37) interposed between the gate insulating film (4, 34) and the embedded insulating film (6, 36).

5. The device according to anyone of claim 1 and 2, **characterized in that** the embedded insulating film (6, 26, 36) is an insulating film formed by reflow.

6. The device according to anyone of claim 1 and 2, **characterized in that** the embedded insulating film (6, 26, 36) formed on the gate electrode (5, 25, 35) has a thickness which satisfy a rated voltage between the gate electrode (5, 25, 35) and the source electrode (8, 28, 38).

7. The device according to claim 6, **characterized in that** the thickness is 0.2 µm or more when the rated voltage is 20 V.

8. The device according to claim 2, **characterized in that** the embedded insulating film (6, 36) has a round surface, and an angle generated by a tangential line on a surface of an end portion of the embedded insulating film (6, 36) with respect to the semiconductor substrate (1, 31) is smaller than 90 degree.

9. The device according to claim 2, **characterized in that** a distance (y) between the top edge of the trench (20, 30) and the tip end of the extending part of the gate insulating film (24, 34) is 0.3 µm or less.

10. A method of manufacturing a semiconductor device, **characterized by** comprising:
forming a drain region (1') in a semiconductor substrate (1), which has one plane exposing on a reverse surface of the semiconductor substrate (1), a base region (2) in the semiconductor substrate (1), which is in contact with the other plane of the drain region (1') and has parts partially exposed at plural portions on a principal plane of the semiconductor substrate (1), a source region (3) in the semiconductor substrate (1), which has one plane being in contact with the base region (2) and the other plane exposed on the principal plane of the semiconductor substrate (1), the source region (3) and the base region (2) being formed to have the same level on the principal plane of the semiconductor substrate (1) and forming a junction plane in the semiconductor substrate (1);
forming a trench (10) from the principal plane of the semiconductor substrate (1) in a vertical direction such that a bottom face of the trench (10) is arranged in the drain region (1');
forming a gate insulating film (4) substantially only on an inner wall of the trench (10);
forming a gate electrode (5) such that the gate electrode (5) is embedded in the trench (10) and a top surface of the gate electrode (5) is situated above the junction plane of the source region (3) and the base region (2) and at a position lower than the principal plane of the semiconductor substrate (1);
depositing an insulating film (6) having a reflow property on the gate electrode (5);
etching the insulating film (6) having the reflow property by dry etching to leave the insulating film (6) at least on an upper portion of the trench (10);
heating the left insulating film (6) so as to reflow; and
forming a source electrode (8) on the principal plane of the semiconductor substrate (1) so as to be in contact with the source region (3) and the base region (2).

11. A method of manufacturing a semiconductor device, **characterized by** comprising:
forming a drain region (21', 31') in a semiconductor substrate (21, 31), which has one plane exposing on a reverse surface of the semiconductor substrate (21, 31), a base region (22, 32) in the semiconductor substrate (21, 31), which is in contact with the other plane of the drain region (21', 31') and has parts partially exposed at plural portions on the principal plane of the semiconductor substrate (21, 31), a source region (23, 33) in the semiconductor substrate (21, 31), which has one plane being in contact with the base region (22, 32) and the other plane exposed on the principal plane of the semiconductor substrate (21, 31), the source region (23, 33) and the base region (22, 32) being formed to have the same level on the principal plane of the semiconductor substrate (21, 31) and forming a junction plane in the semiconductor substrate (21, 31);
forming a trench (20, 30) from the principal plane of the semiconductor substrate (21, 31) in a vertical direction such that a bottom face of the trench (20, 30) is arranged in the drain region (21', 31');
forming a gate insulating film (24, 34) in an inside of the trench (20, 30), and extending on the principal plane of the semiconductor substrate (21, 31);
forming a gate electrode (25, 35) such that the gate electrode is embedded in the trench (20, 30), a surface of the gate electrode (25, 35) is situated above the junction plane of the source region (23, 33) and the base region (22, 32) and at a position lower than the principal plane of the semiconductor substrate (21, 31), and a distance (x) between the principal plane of the semiconductor substrate (21, 31) and the surface of the gate electrode (25, 35) is longer than a distance (y) between a top edge of the trench (20, 30) and an extending end of the gate insulating film (24, 34) on the principal plane of the semiconductor substrate (21, 31);
depositing an insulating film (26, 36) having a reflow property on the gate insulating film (24, 34);
arranging a mask having a predetermined pattern on the insulating film (26, 36) having the reflow property, etching by anisotropic etching with use of the mask, thereby leaving the insulating film (24, 34) having the reflow property on an upper portion of the gate electrode (25, 35) and on the gate insulating film (24, 34) around the trench (20, 30);
performing reflow to the etched insulating film (26, 36) having the reflow property so as to completely embed the insulating film in the trench (20, 30) and make a surface of the insulating film round; and
forming a source electrode (28, 38) coming into contact with the source region (13, 33) and the base region (22, 32) on the principal plane of the semiconductor substrate (21, 31).

12. The method according to anyone of claim 10 and 11, **characterized by** further comprising forming a drain electrode (29, 39) on the reverse surface of the semiconductor substrate (21, 31) so as to be in contact with the drain region (21', 31').

13. The method according to anyone of claim 10 and 11, **characterized by** further comprising forming a silicon nitride film (37) on the principal plane of the semiconductor substrate (21, 31) including the inside of the trench (30), between the forming of the gate electrode (35) and the depositing of the insulating film (36).
